# EUROPEAN PATENT APPLICATION

(11) **EP 2 369 256 A1**
(43) Date of publication of application: **28.09.2011**
(21) Application number: 11158499.1
(22) Date of filing: 16.03.2011
(51) Int. Cl.: F24F 11/00, H05K 7/20, F24F 7/06

(54) **Air conditioning system for server rooms**

(30) Priority: 23.03.2010 IT PD20100092
(71) Applicant: Emerson Network Power S.R.L., 35028 Piove di Sacco (PD) (IT)
(72) Inventor: Felisi, Roberto, 31021 Mogliano Veneto TV (IT); Scattolin, Mario, 30037 Scorze' VE (IT)
(74) Representative: Modiano, Micaela Nadia

(57) **Abstract**

A device (10) for cooling and conditioning an environment (11) that contains a plurality of heat emitting bodies (12), and in particular for server rooms and the like, which comprise:
- at least one air conditioning and cooling unit (14), which is adapted to aspirate heated air (17) from an interspace (15) under the floor (16) and is provided with means (18) for the diffusion of cooled air (19) into the environment,
- means (21) for the conveyance toward said underfloor interspace (15) of air that has been heated by passage through or proximate to one or more heat emitting bodies (12),
- an underfloor interspace (15) for circulating the heated air (17), the heated air originating, by means of corresponding openings (23) in the floor (16), from the heat emitting bodies (12), and being directed toward the at least one cooling and conditioning unit (14).

## Description

The present invention relates to a device for conditioning an environment containing a plurality of heat emitting bodies, and in particular for server rooms and the like.

Server rooms, and in general any site that contains many electronic devices and racks (i.e., supporting frames for a plurality of servers, of electrical, electronic and similar instruments, generally enclosed within adapted ventilated cabinets), require continuous conditioning, adapted to prevent the heat that originates from the computers and from the electronic instruments from accumulating, causing temperatures that are so high as to damage the internal components of such electronic instruments and the like.

Currently, in order to obviate these drawbacks, underfloor conditioning systems are generally installed in server rooms and are increasingly widespread in environments equipped on a raised floor.

The interspace between the ground and the raised floor can in fact be equipped easily not only for the distribution of the connecting and power supply cables of the racks and of the computers, but also as a plenum, i.e., as a passage area for the conditioned air, introduced therein by one or more cooling and conditioning units, such plenums conveying the air to the overlying environment or directly into the rack cabinets by means of floor grilles.

Such a cooling and conditioning system, despite being widespread and widely appreciated, entails drawbacks, the main of which is the high temperature of the air which, after passing inside or flowing externally around the server cabinets, passes into the environment of the server room.

The larger the server cabinets and the higher the density of equipment for each cabinet, the greater the heating of the environment, to the point that it can become a problem for personnel who stays in such environment.

For example, in server rooms that contain cabinets for so-called blade servers, which are extremely compact low-thickness servers that can be supported by a standard cabinet in a number which is three times what can be provided with normal servers, it has been measured that the warmest regions can reach 50°C, a temperature which is definitely unacceptable for a person to work therein.

Furthermore, the high environmental temperature of the server room can propagate also to the adjacent rooms, if an adapted and expensive thermal insulation of the walls and ceiling has not been provided.

The aim of the present invention is to provide a device for cooling and conditioning an environment containing a plurality of heat emitting bodies, and in particular for server rooms, that is capable of obviating the cited drawbacks of known cooling and conditioning systems.

Within this aim, an object of the invention is to provide a device for cooling and conditioning that maintains the ambient temperature of a server room at levels of comfort for personnel who has to stay therein.

Another object of the invention is to provide a device for cooling and conditioning such as to contain the overheating of the environment of the server room, allowing to avoid providing the expensive thermal insulation of its walls and floor.

A further object of the invention is to provide a device for cooling and conditioning that allows to provide higher heat exchange efficiency than known types of means.

Another object of the invention is to propose a device for cooling and conditioning for an environment containing a plurality of heat emitting bodies, and in particular for server rooms and the like, which can be manufactured with components of a per se known type.

This aim, as well as these and other objects that will become better apparent hereinafter, are achieved by a device for cooling and conditioning an environment that contains a plurality of heat emitting bodies, and in particular for server rooms and like, characterized in that they comprise
- at least one air conditioning and cooling unit, which is adapted to aspirate heated air from an interspace under the floor and is provided with means for diffusion of cooled air into the environment,
- means for the conveyance toward said underfloor interspace of air that has been heated by passage through or proximate to a heat emitting body,
- an underfloor interspace for circulating the heated air, said heated air originating, by means of corresponding openings in the floor, from said heat emitting bodies, and being directed toward said at least one cooling and conditioning unit.

Further characteristics and advantages of the invention will become better apparent from the following detailed description of a preferred but not exclusive embodiment of the device for cooling and conditioning according to the invention, illustrated by way of non-limiting example in the accompanying drawings, wherein:
Figure 1 is a schematic view of the device according to the invention;
Figure 2 is a schematic view of a further embodiment of the device according to the invention.

With reference to the figures, the device according to the invention for cooling and conditioning an environment that contains a plurality of heat emitting bodies and in particular for server rooms and the like is generally designated by the reference numeral 10.

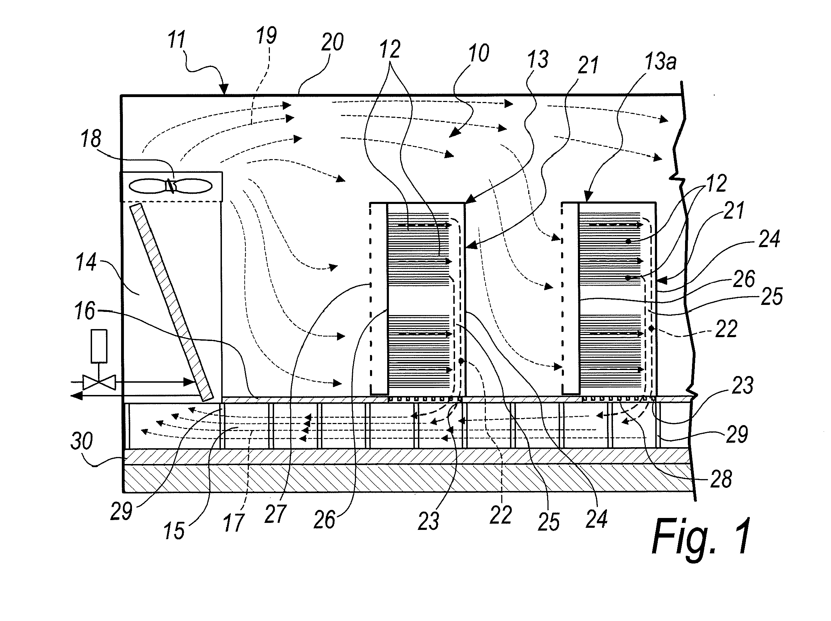

In the embodiment described here, the device 10 according to the invention is dedicated to the cooling and conditioning of an environment 11 which is a server room, inside which there is a plurality of heat emitting bodies 12, constituted by servers, which are grouped within server cabinets, two of which are shown schematically in Figure 1 and designated by the reference numerals 13 and 13a.

The means 10 comprise first of all at least one air conditioning and cooling unit 14, for example a conditioning machine for server rooms of a per se known type.

The unit 14 is adapted to aspirate heated air 17 from an interspace 15 under the floor 16.

The unit 14 is provided with means 18, for example one or more fans, for diffusing cooled air 19 into the environment.

The cooled air 19 is emitted substantially in the direction of the ceiling 20 by the fans 18, which are arranged above the cooling and conditioning unit 14 and are directed substantially toward the ceiling 20.

The device 10 according to the invention comprises means 21 for conveying toward the interspace 15 under the floor air 22 which is heated by passing through or proximate to a heat emitting body 12, i.e., a server.

Furthermore, the device 10 according to the invention comprises the same interspace 15 under the floor 16 for the circulation of the heated air, such heated air arriving, by means of corresponding openings 23 on the floor 16, from the heat emitting bodies 12 and being directed, by means of the interspace 15, toward the cooling and conditioning unit 14.

The conveyance means 21 are constituted by the back 24 of each server cabinet 13, 13a, which defines with such servers a channel 25 for the descent of the heated air toward the floor, and by partitions 26 for preventing recirculation, which prevent the heated air from recirculating toward the server inlet region of the server cabinets 13 and 13a, at the front door with grilles 27 of the cabinets 13 and 13a; a recirculation preventing partition 26 is arranged inside a same server cabinet 13, 13a, between two servers between which there is a space that is not filled by other servers and would indeed form a recirculation channel if it were not obstructed by an adapted partition.

The descent channels 25 for the heated air 22 are connected to the interspace 15 under the floor by means of the openings 23, which are provided with protective grilles 28.

The floor 16 is a raised floor, of which the posts 29 are shown schematically, and the interspace 15 is formed between the raised floor 16 and the foundation 30 on which it rests.

The floor 16 is thermally insulated with per se known systems in order to prevent the heat in the interspace 15 from rising into the environment inside the room.

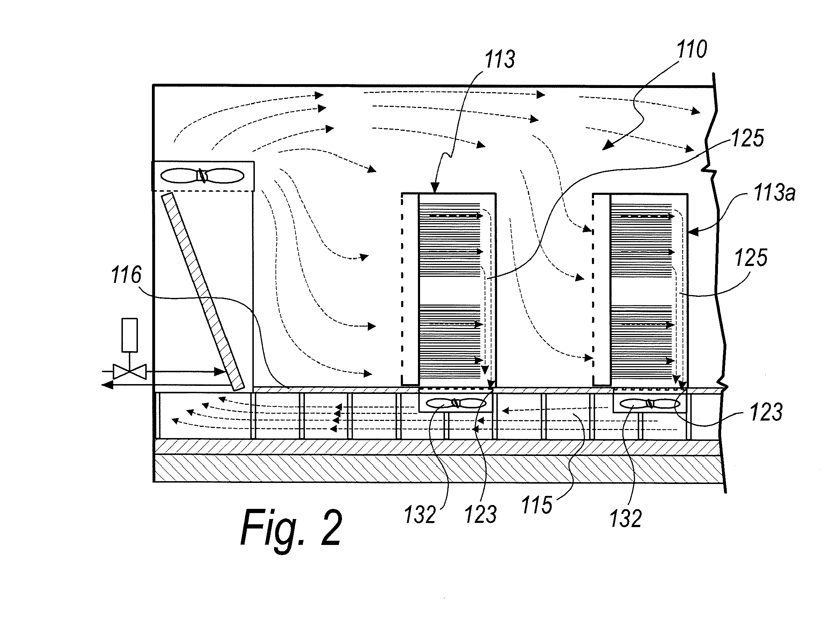

In a further embodiment of the device according to the invention, designated by the reference 110 in Figure 2, each server cabinet 113, 113a has, at the floor 116 and at the opening 123 for the passage of heated air, means 132 for aspirating the heated air from the descent channel 125 toward the underfloor interspace 115; such suction means can be constituted by blowers, fans and impellers in general, of a per se known type.

The operation of the cooling and conditioning device 10, particularly for a server room as described above, therefore provides for the cooling and air conditioning unit 14 to draw heated air 17 from the interspace 15 defined below the raised floor 16, in order to reintroduce it, after being cooled, into the environment in the vicinity of the ceiling 20.

The cooled air 19 penetrates into the server cabinets 13 and 13a and flows over of the various servers 12 contained in such cabinets, removing the excess heat from them.

The heated air 22 is conveyed into the descent channels 25 at the backs 24 of the cabinets and by means of the openings 23 in the floor 16 reaches the interspace 15, from where it is again aspirated by the unit 14.

In practice it has been found that the invention achieves the intended aim and objects.

First of all, the invention provides a cooling and air conditioning device that allows to provide higher heat exchange efficiency with respect to conventional devices, thanks to the confinement of the warm air that exits from the rack cabinets in the interspace under the floor, and by striking the heat exchanger of the conditioning unit with air that has a higher temperature than the air that strikes the conditioning unit in known systems; this leads to a higher overall efficiency and to a lower cost as regards the exchanger.

In particular, the invention provides a cooling and conditioning device that maintains the ambient temperature of a server room at comfortable levels for personnel who has to stay therein, since air that has just been cooled, instead of heated air exiting from the server cabinets as occurs in known systems, is introduced into the environment.

Furthermore, the invention provides a cooling and conditioning device which is such as to contain the overheating of the environment of the server room, so that it is not necessary to provide thermal insulation of the walls and ceiling, but optionally only of the floor if necessary.

Moreover, the invention provides a cooling and conditioning device for an environment that contains a plurality of heat emitting bodies, and in particular for server rooms and the like, which can be provided by means of components of a per se known type.

The invention thus conceived is susceptible of numerous modifications and variations, all of which are within the scope of the appended claims; all the details may further be replaced with other technically equivalent elements.

In practice, the materials used, as well as the contingent shapes and dimensions, may be any according to requirements and to the state of the art.

The disclosures in Italian Patent Application No. PD2010A000092 from which this application claims priority are incorporated herein by reference.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A device (10) for cooling and conditioning an environment (11) that contains a plurality of heat emitting bodies (12), and in particular for server rooms and the like, **characterized in that** it comprises
- at least one air conditioning and cooling unit (14), which is adapted to aspirate heated air (17) from an interspace (15) under a floor (16; 116) and is provided with means (18) for the diffusion into the environment of cooled air (19),
- means (21) for the conveyance toward said underfloor interspace (15) of air that has been heated by passage through or proximate to one or more heat emitting bodies (12),
- an underfloor interspace (15) for circulating the heated air (17), said heated air originating, by means of corresponding openings (23) in the floor (16), from said heat emitting bodies (12), and being directed toward said at least one cooling and conditioning unit (14).

2. The device according to claim 1, **characterized in that** said heat emitting bodies (12) are constituted by servers which are contained in corresponding server cabinets (13, 13a), said conveyance means (21) being constituted by the back (24) of each server cabinet (13, 13a), which forms with said servers a channel (25) for the descent of the heated air toward the floor (16), and by partitions (26) for preventing the recirculation of the heated air, which are arranged between two spaced servers within a same server cabinet (13, 13a).

3. The device according to claim 2, **characterized in that** said channels (25) for the descent of heated air are connected to said underfloor interspace (15) by means of said openings (23), which are provided with protective grilles (28).

4. The device according to claim 3, **characterized in that** said floor (16) is a raised floor, said underfloor interspace (15) being formed between said raised floor (16) and the foundation (30) on which it rests.

5. The device according to claim 1, **characterized in that** said floor (16) is thermally insulated.

6. The device according to claim 2, **characterized in that** each server cabinet (113, 113a) has, at a floor (116) and at an opening (123) for the passage of heated air, means (132) for aspirating the heated air from said descent channel toward said underfloor interspace.
